# EUROPEAN PATENT APPLICATION

(11) **EP 3 399 075 A1**
(43) Date of publication of application: **07.11.2018**
(21) Application number: 16881446.5
(22) Date of filing: 28.12.2016
(51) Int. Cl.: C30B 29/36, C30B 19/04

(54) **METHOD FOR MANUFACTURING SINGLE-CRYSTAL SiC, AND HOUSING CONTAINER**

(30) Priority: 28.12.2015 JP 2015256444
(71) Applicant: Toyo Tanso Co., Ltd., Osaka-shi, Osaka 555-0011 (JP)
(72) Inventor: YABUKI, Norihito, Kanonji-shi Kagawa 769-1612 (JP); TORIMI, Satoshi, Kanonji-shi Kagawa 769-1612 (JP)
(74) Representative: TBK
(86) International application number: PCT/JP2016/005245
(87) International publication number: WO 2017/115466

(57) **Abstract**

Provided is a method for producing high-purity SiC single crystal, which is applicable to a process of growing SiC single crystal through a solution growth method. This method is for producing SiC single crystal and includes growing, through a solution growth method, an epitaxial layer on a seed material, at least a surface of which is made of SiC, wherein the SiC single crystal is grown so that impurity concentrations therein measured by secondary ion mass spectrometry are very small. Also provided is a housing container for growing SiC single crystal through a solution growth method using a Si melt, including a feed material that is disposed on at least a surface of the housing container and adds, to the Si melt, an additional material that is SiC and/or C. Performing the solution growth method using this housing container can produce high-purity SiC single crystal without any special treatment.

## Description

### Technical Field

The present invention mainly relates to a technique for producing silicon carbide (SiC) single crystal through a solution growth method.

### Background Art

SiC has more excellent properties such as electric characteristics than those of other materials such as silicon (Si). As a new semiconductor material, therefore, SiC attracts attention. In order to manufacture a semiconductor device, a SiC substrate, SiC bulk crystal, or the like is first produced from seed crystal (SiC single crystal substrate) that is made of SiC. Known methods for growing SiC single crystal from a seed crystal encompass solution growth methods (for example, metastable solvent epitaxy (MSE) method).

Patent Literature 1 (hereinafter, referred to as PTL 1) discloses a method for growing SiC single crystal through the MSE method. The MSE method is one of the solution growth methods, and uses a SiC single crystal substrate, a feed substrate (feed layer) having a higher free energy than the SiC single crystal substrate, and a silicon (Si) melt. The SiC single crystal substrate and the feed substrate are disposed opposite to each other, and the Si melt is interposed between the SiC single crystal substrate and the feed substrate. Then, the resulting stack is heated under vacuum. Consequently, SiC single crystal can be grown on a surface of the SiC single crystal substrate.

Patent Literatures 2 and 3 (hereinafter, referred to as PTLs 2 and 3) each disclose a method for growing SiC single crystal from a SiC single crystal substrate through another type of solution growth method. In addition, PTLs 2 and 3 disclose addition of metals (e.g., titanium (Ti), tin (Sn), germanium (Ge), aluminum (Al)) to a Si melt. The addition of the metals to the Si melt can increase the amount of carbon (C) dissolved in the Si melt. Consequently, it is possible to enhance the growth rate of the SiC single crystal.

### Citation List

### Patent Literature

PTL 1: Japanese Patent Application Laid-Open No. 2008-230946
PTL 2: Japanese Patent Application Laid-Open No. 2008-303125
PTL 3: Japanese Patent Application Laid-Open No. 2007-277049

### Non-Patent Literature

NPL 1: K. Danno et al. "High-Speed Growth of High-Quality 4H-SiC Bulk by Solution Growth using Si-Cr Based Melt", Mater. Sci. Forum 2010, vol. 645-648, pp. 13-16
NPL 2: R. I. Scace et al., "Solubility of Carbon in Silicon and Germanium", J. Chem. Phys. 1959, 30, 1551

### Summary of Invention

### Technical Problem

Incidentally, NPL 1 discloses impurity concentrations in SiC single crystal that was grown on a SiC single crystal substrate through a solution growth method in which chromium (Cr) was added to a Si melt. NPL 1 discloses that the SiC single crystal grown by this method contained 7 - 40 × 10¹⁶ atoms/cm³ of Cr and 4 - 20 × 10¹⁷ atoms/cm³ of Al. As described above, according to the method in which metals are added to a Si melt, the added metals may potentially be taken into the resulting SiC single crystal. Thus, it is difficult to produce high-purity SiC single crystal.

Some aspects of the present invention have been made in view of the foregoing circumstances, and have a main object to provide a method for producing high-purity SiC single crystal, the method being applicable to a process of growing SiC single crystal through a solution growth method.

### Solution to Problem and Advantageous Effects

The problem to be solved by some aspects of the present invention has been described above. Next, the following will describe solutions to this problem and effects achieved thereby.

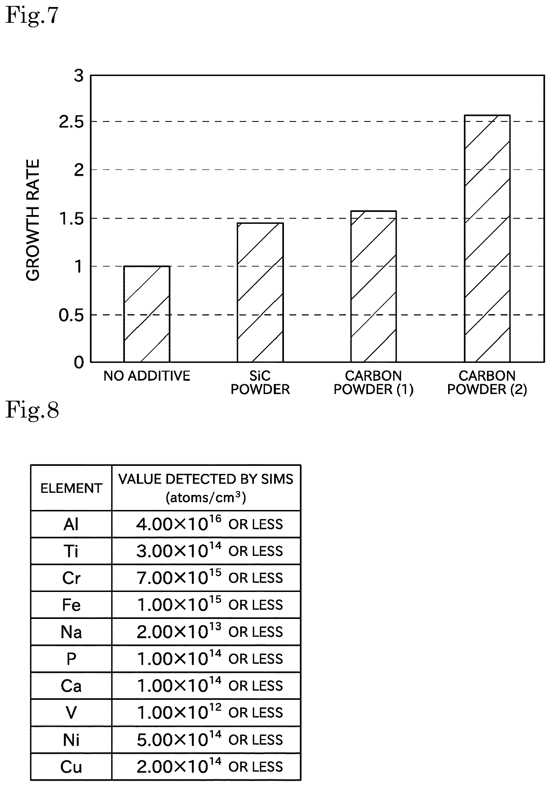

According to a first aspect of the present invention, a method for producing SiC single crystal that includes growing, through a solution growth method, an epitaxial layer on a seed material, at least a surface of which is made of silicon carbide, is preferably configured such that impurity concentrations in the SiC single crystal measured by secondary ion mass spectrometry satisfy the conditions regarding Al, Ti, Cr, and iron (Fe) shown in FIG. 8, and is further preferably configured such that the impurity concentrations satisfy also the conditions regarding the other elements shown in FIG. 8.

According to this method, it is possible to produce high-purity SiC single crystal through a solution growth method.

In the above-described method for producing the SiC single crystal, an additional material that is at least one of SiC and C is preferably added to a Si melt before the growth of the epitaxial layer is ended.

According to this method, SiC or C, each of which is a material of the epitaxial layer, is added as the additional material, and other metals that are impurities are not added as the additional materials. Since the additional material is not an impurity for the SiC single crystal, it is possible to produce high-purity SiC single crystal while preventing reduction in the growth rate of the SiC single crystal.

In the above-described method for producing the SiC single crystal, a heating treatment is preferably performed on a housing container in which the seed material, solid-state Si, a first feed material that feeds at least C to a Si melt, and the additional material that is in a solid state exist so that the solid-state Si is melted into a Si melt and the additional material is added to the Si melt.

Thus, it is possible to add the additional material to the Si melt merely by performing the heating treatment.

In the above-described method for producing the SiC single crystal, the additional material that is in a solid state is preferably powdery.

With the powdery additional material, which has a large area coming in contact with the Si melt, it is possible to add the additional material to the Si melt efficiently.

In the above-described method for producing the SiC single crystal, the epitaxial layer is preferably grown with the housing container in which a first feed material that feeds at least C to a Si melt and a second feed material that adds the additional material to the Si melt exist.

According to this method, C can be fed with a simpler configuration than a configuration in which C is fed from other materials such as a hydrocarbon gas. With the second feed material containing a large amount of additional material, it is possible to perform the solution growth method a plurality of times without replacing the second feed material with a new one.

In the above-described method for producing the SiC single crystal, the additional material is preferably SiC.

According to this method, the additional material is identical to the material of the resulting product. Consequently, it is possible to further increase the possibility of preventing a decrease in the purity of the SiC single crystal.

In the above-described method for producing the SiC single crystal, the additional material is preferably more soluble in the Si melt than the seed material.

According to this method, it is possible to add the additional material to the Si melt efficiently.

In the above-described method for producing the SiC single crystal, the additional material is preferably C.

According to this method, it is possible to further enhance the growth rate of the SiC single crystal while increasing the possibility of preventing a decrease in the purity of the SiC single crystal, as compared with the case where SiC is added as the additional material.

In the above-described method for producing the SiC single crystal, the additional material is preferably C having a true density of 2 Mg/m³ or less.

According to this method, it is possible to further enhance the growth rate of the SiC single crystal, as compared with a case where C having a true density higher than 2 Mg/m³ is added as the additional material.

In the above-described method for producing the SiC single crystal, an amount of the additional material to be added to the Si melt is preferably 1% or more and not more than 3% in an amount-of-substance ratio.

According to this method, the amount of the additional material to be added is the same or similar to 2 at.% (atomic percent), which is equal to a solubility of C in a Si melt at approximately 2000 °C. This allows the Si melt to contain a necessary and sufficient content of the additional material.

According to a second aspect of the present invention, a housing container for growing SiC single crystal through a solution growth method involving use of a Si melt includes a feed material disposed on at least a surface of the housing container, the feed material adding, to the Si melt, an additional material that is at least one of SiC and C.

By performing the solution growth method with use of this housing container, it is possible to produce high-purity SiC single crystal without performing any special treatment.

### Brief Description of Drawings

[FIG. 1] A view illustrating an overview of a high-temperature vacuum furnace to be used in a heating treatment.
[FIG. 2] A view illustrating a state in which a powdery additional material and Si pellets are being charged into a housing container.
[FIG. 3] A view illustrating a state in which the Si pellets have been melted after the Si pellets were charged into the housing container.
[FIG. 4] A view illustrating a state in which a first feed material and a cap layer have been formed above a Si melt.
[FIG. 5] A view illustrating a state in which SiC single crystal is being grown by the MSE method.
[FIG. 6] A diagram showing compositions and true densities of additional materials used in an experiment.
[FIG. 7] A graph showing differences between growth rates of respective SiC single crystals produced with the additional materials that were added.
[FIG. 8] A table showing rough standard values of lower detection limits of elements obtained when secondary ion mass spectrometry was performed on SiC single crystal.
[FIG. 9] A view illustrating a state in which SiC single crystal is being grown in a housing container according to a first modification.
[FIG. 10] A view illustrating a state in which SiC single crystal is being grown in a housing container according to a second modification.
[FIG. 11] A view illustrating a state in which SiC single crystal is being grown in a housing container according to a third modification.
[FIG. 12] A view illustrating a state in which SiC single crystal is being grown in a housing container according to a fourth modification.

### Description of Embodiments

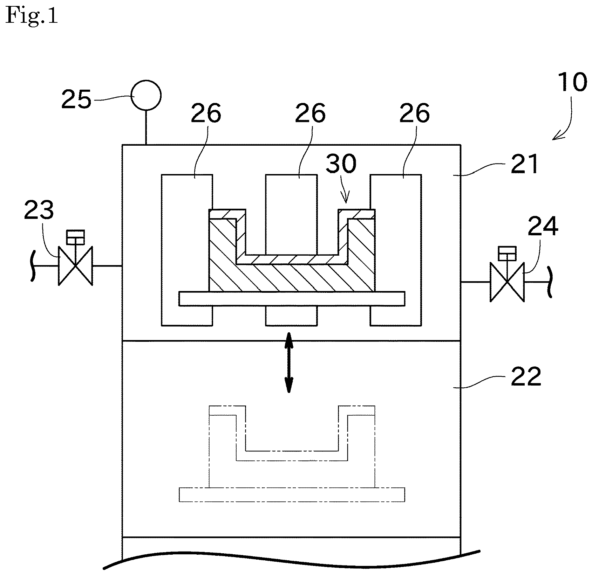

Next, with reference to the drawings, embodiments of the present invention will be described. First, with reference to FIG. 1, a high-temperature vacuum furnace 10 to be used in a heating treatment of the present embodiment will be described.

As illustrated in FIG. 1, the high-temperature vacuum furnace 10 includes a main heating chamber 21 and a preliminary heating chamber 22. In the main heating chamber 21, a subject to be processed (e.g., SiC seed crystal or a SiC substrate), at least a surface of which is made of SiC single crystal, can be heated at a temperature of 1000 °C or more and not more than 2300 °C. The preliminary heating chamber 22 is a space in which the subject to be processed is preliminary heated prior to heating of the subject in the main heating chamber 21.

The main heating chamber 21 is connected to a valve 23 for vacuum formation, a valve 24 for inert gas injection, and a vacuum gauge 25. The valve 23 for vacuum formation can adjust a degree of vacuum in the main heating chamber 21. The valve 24 for inert gas injection can adjust a pressure of an inert gas (e.g., an argon (Ar) gas) in the main heating chamber 21. The vacuum gauge 25 can measure a degree of vacuum in the main heating chamber 21.

The main heating chamber 21 includes, in its inside, a heater 26. The main heating chamber 21 has a side wall and a ceiling to which heat-reflecting metal plates (not illustrated) are fixed. The heat-reflecting metal plates are each configured to reflect heat from the heater 26 toward the center of the main heating chamber 21. With this configuration, the subject to be processed can be strongly and uniformly heated so that the temperature of the subject reaches a temperature of 1000 °C or more and not more than 2300 °C. The heater 26 can be, for example, a resistance heater or a high-frequency induction heater.

The high-temperature vacuum furnace 10 includes a support table on which a housing container 30 is placed. By moving the support table, it is possible to move the housing container 30 at least from the preliminary heating chamber to the main heating chamber. In the housing container 30, SiC seed crystal is contained, for example. By heating the housing container 30 with the high-temperature vacuum furnace 10 under a predetermined condition, it is possible to grow SiC single crystal through the MSE method (this will be described in detail later).

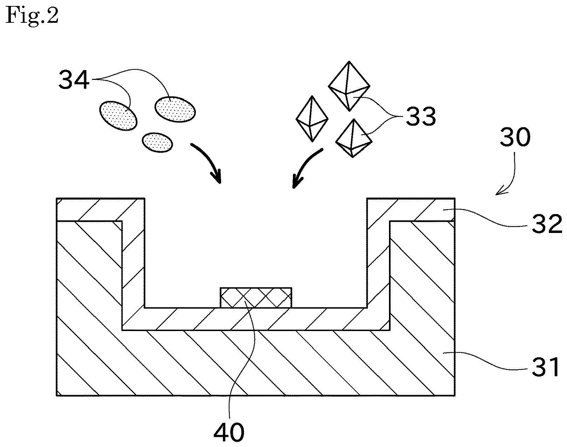

Next, with reference to FIGs. 2 to 5, the following will describe a method for growing SiC single crystal (epitaxial layer) through the MSE method, which is one of the solution growth methods. FIGs. 2 to 5 are views illustrating a flow of a process for growing SiC single crystal through the MSE method.

The housing container 30 illustrated in FIG. 2 includes a base material 31 having a surface on which a seed layer 32 is formed. The base material 31 is made of high-purity graphite containing less metal impurities. The base material 31 is not limited to the one made of graphite. Alternatively, the base material 31 may be made of SiC, for example. In addition, as illustrated in FIG. 2, the base material 31 has a recess in which an epitaxial growth method is performed according to the MSE method.

The seed layer 32 is SiC single crystal or SiC polycrystal formed on the surface of the base material 31. The seed layer 32 is formed on the surface of the base material 31 through, e.g., a chemical vapor deposition (CVD). Alternatively, a SiC substrate that is in a solid state may be disposed on the surface of the base material 31. The seed layer 32 is formed along the base material 31. Even after the seed layer 32 is formed, therefore, the recess exists.

As illustrated in FIG. 2, SiC seed crystal 40 (SiC single crystal) is disposed in the recess of the seed layer 32. In the present embodiment, the SiC seed crystal 40 serves as a seed material. Alternatively, the seed layer 32 may serve as the seed material. Note that the seed layer 32 is not an essential constituent element, and the SiC seed crystal 40 may be disposed in the recess of the base material 31.

Si pellets 33 and an additional material 34 are also charged into the recess of the seed layer 32. The Si pellets 33 are solid-state Si, and are a material from which a Si melt (described later) is to be formed. Instead of the Si pellets 33, a Si plate may be used.

The additional material 34 is an additional material to be added to a Si melt 33a obtained by heating and melting the Si pellets 33. In the present embodiment, a powdery additional material 34 (that is in a solid state before a heating treatment) is used. In the present embodiment, the additional material 34 is SiC or C. Alternatively, the additional material 34 may be a mixture of SiC and C. Instead of the powdery additional material 34, an additional material 34 in the form of pellets may be used.

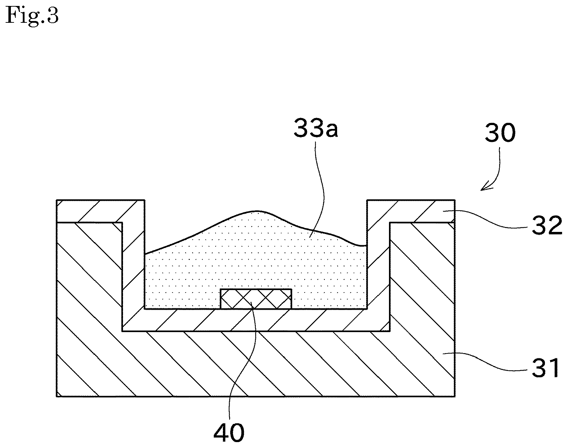

After the Si pellets 33 and the additional material 34 are placed in the recess of the housing container 30, a heating treatment is performed. The heating treatment is performed at a temperature (e.g., 1400 °C) at which Si is melted. Consequently, as illustrated in FIG. 3, Si is melted into a Si melt 33a. Furthermore, the additional material 34 is added to the Si melt 33a.

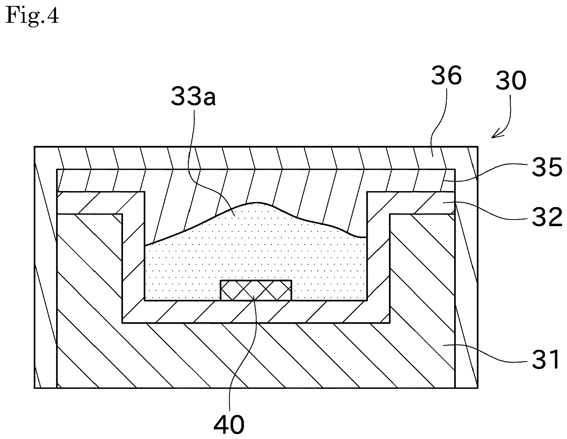

Next, as illustrated in FIG. 4, a first feed material 35 for feeding a carbon atom and a cap layer 36 for covering the first feed material 35 and the like are formed.

The first feed material 35 is used as a member for feeding carbon, that is, as a feed side. The first feed material 35 is a material which is made of, e.g., polycrystalline 3C-SiC and which has a higher free energy than the SiC seed crystal 40. The first feed material 35 may be a SiC polycrystal substrate or a film made of SiC polycrystal produced through, e.g., CVD.

The cap layer 36 is provided to suppress or reduce evaporation of the first feed material 35, the Si melt 33a, and the like. The cap layer 36 is, for example, a carbon layer produced through CVD. The carbon layer may have any composition. Note that the cap layer 36 is not an essential constituent element, and may be omitted.

Next, after the cap layer 36 is formed, heating is performed at a high temperature under vacuum. The heating is preferably performed at a temperature of 1500 °C or more and not more than 2300°C, for example. In the present embodiment, a concentration gradient is generated in the Si melt 33a due to a difference in free energy between the SiC seed crystal 40 and the first feed material 35, and the concentration gradient provides a driving force to elute C from the first feed material 35 into the Si melt 33a. Then, C taken into the Si melt 33a moves downward (toward the SiC seed crystal 40), and is deposited on a surface of the SiC seed crystal 40 to form SiC single crystal thereon.

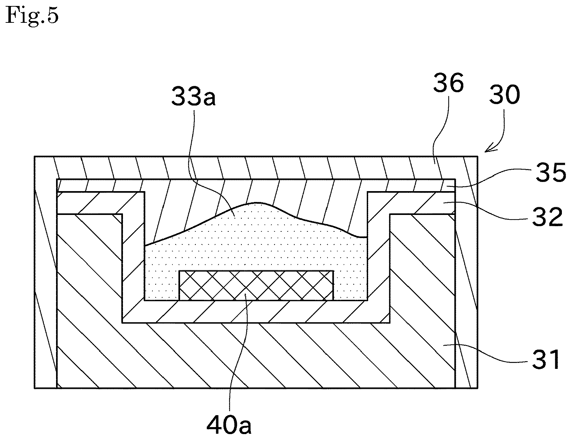

By growing the SiC single crystal from the SiC seed crystal 40 through the MSE method in the above-described manner, it is possible to produce a SiC single crystal layer 40a (see FIG. 5). In the above-described manner, it is possible to produce a SiC substrate which has less micropipes or crystal defects and which is flat at an atomic level. On the SiC substrate, steps such as a step of growing an epitaxial layer, a step of injecting ions, and an annealing step (heating step) in which the ions are activated may be performed. Consequently, a semiconductor device is obtained.

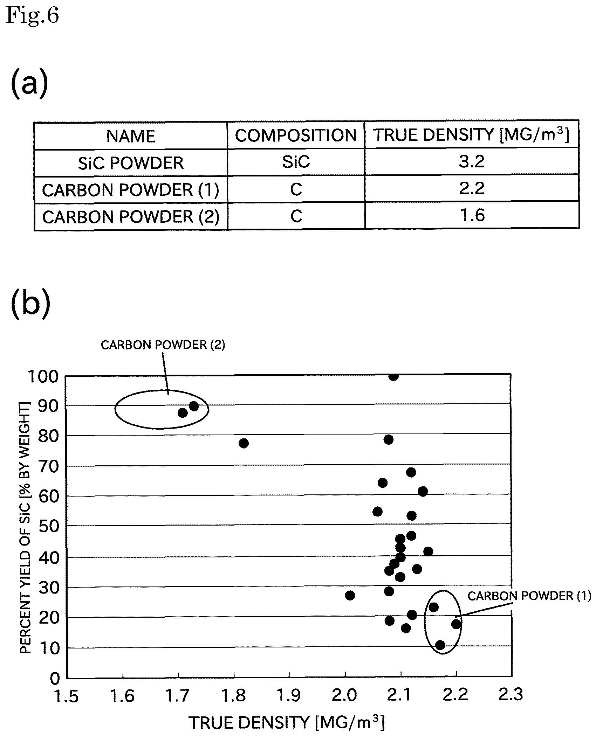

Next, the following will describe an experiment conducted to verify whether or not addition of an additional material 34 to a Si melt 33a enhanced a growth rate given by the MSE method. FIG. 6 is a view illustrating compositions and true densities of additional materials used in the experiment. FIG. 7 is a graph illustrating a difference between growth rates of respective SiC single crystals produced with the additional materials that were added.

As shown in FIG. 6(a), the additional materials used in this experiment were SiC powder, carbon powder (1), and carbon powder (2). As shown in FIGs. 6(a) and 6(b), the carbon powder (1) and the carbon powder (2) had different true densities. Specifically, the carbon powder (1) had a higher true density than the carbon powder (2). It is generally known that carbon powder having a higher true density is less likely to cause a reaction.

In this experiment, samples prepared by adding the three types of additional materials 34 listed in FIG. 6(a) to Si melts 33a and a sample that is a Si melt 33a to which no additional material 34 was added were subjected to the MSE method at 2000 °C under an argon atmosphere of 13.3 kPa. FIG. 7 is a graph showing growth rates thereof, where 1 represents a growth rate observed in the Si melt 33a to which no additional material 34 was added.

The results in FIG. 7 show that the addition of the additional material enhanced the growth rate of the SiC single crystal. The results in FIG. 7 also show that the addition of the carbon powder enhanced the growth rate more than the addition of the SiC powder. Especially, the results in FIG. 7 show that the addition of the carbon powder (2), which had a lower true density, enhanced the growth rate significantly more than the addition of the carbon powder (1). Considering this, the true density is preferably 2.2 Mg/m³ or less (more preferably, 2 Mg/m³ or less).

In the above experiment, the amount of each of the additional materials 34 to be added was not particularly taken into consideration. In this respect, however, considering the fact that a solubility of a carbon atom in a Si melt 33a at approximately 2000 °C is generally considered to be approximately 2% in an amount-of-substance ratio, it seems to be preferable that an amount of the additional material 34 to be added is the same or similar amount to the above (for example, 1% or more and not more than 3%).

Each of SiC and C is an element constituting SiC single crystal. By using SiC or C as an additional material, therefore, it is possible to more significantly improve the purity of SiC, as compared with a case where another metal is used as an additive. Specifically, the Applicant of the present application conducted an experiment to measure, by secondary ion mass spectrometry (SIMS), impurity concentrations in SiC single crystal produced with use of SiC or C as the additional material. As a result of the experiment, the values shown in FIG. 8 were obtained. Specifically, the Cr and Al impurity concentrations were reduced by one or more digits, as compared with those in NPL 1. Thus, by growing SiC single crystal by the method of the present embodiment, it is possible to produce SiC single crystal having a purity satisfying the values in the table in FIG. 8. That is, by the method of the present embodiment, it is possible to produce SiC single crystal having a purity that could not have been achieved by known solution growth methods.

It is especially preferable that contents of Al, Ti, Cr, and Fe be the values indicated below. With this configuration, the Cr and Al impurity concentrations are reduced by three or more digits, as compared with those in NPL 1.
2.00 × 10⁻¹³ or less of Al
1.00 × 10⁻¹³ or less of Ti
5.00 × 10⁻¹³ or less of Cr
2.00 × 10⁻¹⁴ or less of Fe

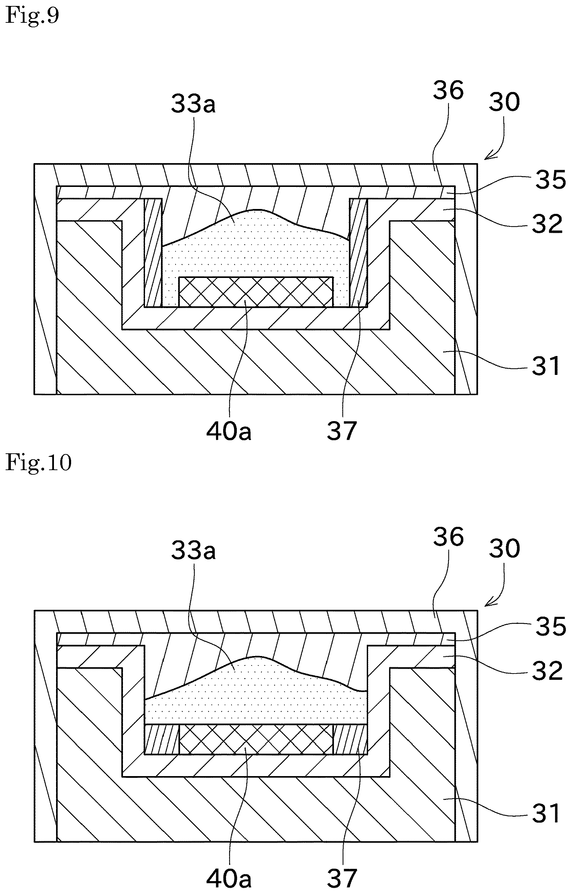

Next, with reference to FIGs. 9 to 12, modifications of the present embodiment will be described. In the modification described below, instead of the powdery additional material 34, a second feed material (feed material) 37 illustrated in FIG. 9 is used, for example. At least a surface of (the whole of or only the surface of) the second feed material 37 is made of an additional material 34. The second feed material 37 is used in a state in which second feed material 37 is fixed to a housing container 30. Alternatively, the second feed material 37 may be used in a state in which second feed material 37 is not fixed to the housing container 30. In the present modification, the housing container 30 and the second feed material 37 are detachably attached to each other. Alternatively, the housing container 30 and the second feed material 37 may not be detachable from each other (may be welded to each other, for example).

A heating treatment is performed in a manner similar to the above-described manner, after the second feed material 37 is fixed to the housing container 30 and in a state where SiC seed crystal 40 and Si pellets 33 exist in the housing container 30. Consequently, the Si pellets 33 are turned into a Si melt 33a. In addition, the additional material 34 in the surface of the second feed material 37 is dissolved into the Si melt 33a, so that the additional material 34 is added to the Si melt 33a.

Consequently, as described above, it is possible to produce high-purity SiC single crystal while preventing reduction in the growth rate of the SiC single crystal. The second feed material 37 contains a sufficient amount of additional material 34. In the MSE method performed a plurality of times, therefore, it is possible to add the additional material 34 to the Si melt 33a without replacing the second feed material 37 with a new one.

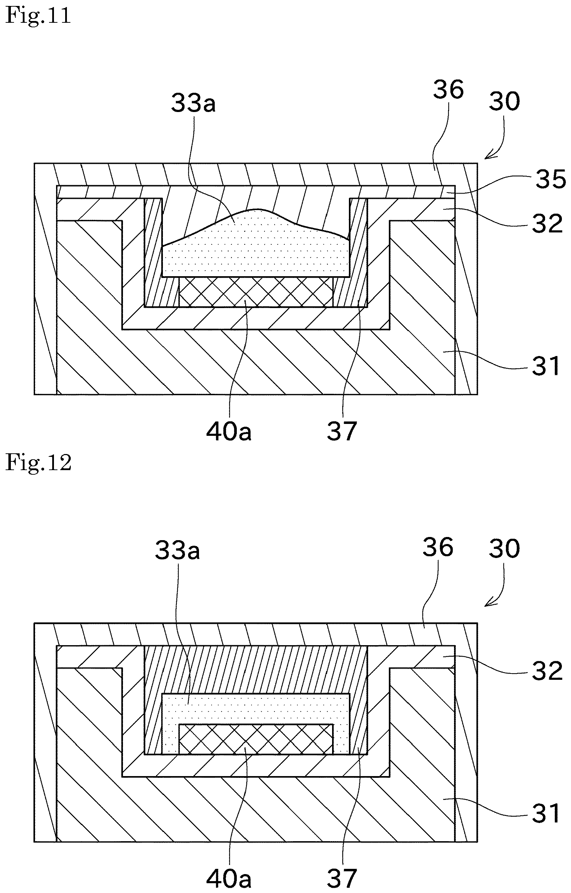

The following will describe one example of a shape of the second feed material 37. FIG. 9 (first modification) shows the second feed material 37 having a substantially cylindrical shape which surrounds lateral sides of the SiC seed crystal 40 (SiC layer 40a) and which is higher (in a vertical direction (in a c-axis direction of a single crystal)) than the SiC seed crystal 40. FIG. 10 (second modification) shows a second feed material 37 having a substantially ring shape which is lower than the second feed material 37 of FIG. 9. FIG. 11 (third modification) shows a second feed material 37 constituted by an inner portion which has a substantially ring shape and which is in close contact with SiC seed crystal 40 (SiC layer 40a) and an outer portion which has a substantially cylindrical shape and which is longer in a vertical direction than the inner portion. FIG. 12 (fourth modification) shows a second feed material 37 that is a substantially cylindrical columnar member having a recess of a substantially cylindrical shape. The second feed material 37 in FIG. 12 is disposed so that its recess faces downward to cover SiC seed crystal 40 (SiC layer 40a). In the configuration of FIG. 12, the SiC seed crystal 40 is fully covered, and therefore a first feed material 35 is not provided. In this respect, however, the second feed material 37 functions also as a feed material. The second feed materials 37 of FIGs. 9 to 11, with which the SiC seed crystals 40 are not fully covered, also function as supply sources of C. The first feed materials 35, therefore, can be omitted from the configurations of FIGs. 9 to 11.

Next, the following will describe a structure of the second feed material 37. The additional material 34 in the surface of the second feed material 37 has a configuration with which the additional material 34 is more soluble in the Si melt 33a than the base material 31, the SiC seed crystal 40, and the first feed material 35 in order that a large amount of the additional material 34 can be dissolved into the Si melt 33a. The following will describe a condition under which SiC is easily soluble in a solution. In terms of polymorphism, 3C-SiC is the most soluble, and 6H-SiC is the second most soluble. Of the three forms of polymorphism, 4H-SiC is the least soluble. In terms of the shape of SiC, the one having a larger area coming in contact with a solution is more soluble in the solution. The one having unevenness and/or surface roughness is therefore more soluble in the solution. Thus, for example, SiC having a lower density (i.e., having more gaps) is more suitable as the second feed material 37. In a case where the housing container 30 itself is made of SiC having a low density, the Si melt 33a may potentially be leaked from the gaps in the housing container 30. In order to avoid this, in the present embodiment, the second feed material 37 is provided separately from the housing container 30.

As described above, according to the present embodiment, the method for producing SiC single crystal (SiC layer 40a) that includes growing, through a solution growth method (in the present embodiment, the MSE method), an epitaxial layer on the seed crystal 40, at least a surface of which is made of SiC, is configured such that impurity concentrations in the SiC single crystal measured by secondary ion mass spectrometry satisfy the conditions shown in FIG. 8.

According to this method, it is possible to produce high-purity SiC single crystal through a solution growth method.

In addition, in the present embodiment, the additional material 34 is added to the Si melt 33a before the growth of the epitaxial layer is ended (in the present embodiment, before the growth of the epitaxial layer starts).

According to this method, the additional material 34 of the present embodiment is SiC or C, each of which is not an impurity for SiC single crystal. It therefore is possible to produce high-purity SiC single crystal while preventing reduction in the growth rate of the SiC single crystal.

In addition, in the present embodiment, a heating treatment is performed on the housing container 30 in which the SiC seed crystal 40, the Si pellets 33, and the additional material 34 exist so that the Si pellets 33 are melted into a Si melt 33a and the additional material 34 is added to the Si melt 33a.

Thus, it is possible to add the additional material 34 to the Si melt 33a merely by performing the heating treatment.

In the present embodiment, the powdery additional material 34 is used.

With the powdery additional material 34, which has a large area coming in contact with the Si melt 33a, it is possible to add the additional material 34 to the Si melt 33a efficiently.

In a modification of the present embodiment, a housing container 30 is provided with a second feed material 37, at least a surface of which is a solid additional material 34.

Thus, the second feed material 37 of the present embodiment contains a large amount of the additional material 34. Consequently, it is possible to perform the solution growth method a plurality of times without replacing the second feed material 37 with a new one.

In the present embodiment, one example of the additional material 34 is SiC.

Thus, the additional material 34 is identical to the material of the resulting product. Consequently, it is possible to further increase the possibility of preventing a decrease in the purity of the SiC single crystal.

In the present embodiment, one example of the additional material 34 is C.

This configuration makes it possible to further enhance the growth rate of the SiC single crystal while increasing the possibility of preventing a decrease in the purity of the SiC single crystal, as compared with the configuration in which SiC is added as the additional material.

In the present embodiment, one example of the additional material is C having a true density of 2 Mg/m³ or less (carbon powder (2)).

This configuration makes it possible to further enhance the growth rate of the SiC single crystal, as compared with a configuration in which C having a true density higher than 2 Mg/m³ is added as the additional material.

In addition, according to the description of the present embodiment, the amount of the additional material 34 to be added to the Si melt is 1% or more and not more than 3% in an amount-of-substance ratio.

Thus, the amount of the additional material 34 to be added is the same or similar to 2 at.% (atomic percent), which is equal to a solubility of C in a Si melt at approximately 2000 °C. This allows the Si melt to contain a necessary and sufficient content of the additional material.

The foregoing description has dealt with preferred embodiments of the present invention. The configurations described above, however, can be modified as below, for example.

The above-described equipment for performing the MSE method is merely one example, and can be modified as appropriate. For example, instead of the high-temperature vacuum furnace 10 described above, any of other heating devices may be used. For another example, a container that is different in shape and material from the housing container 30 may be used.

The additional material 34 may be charged into the container at any timing, as long as the additional material 34 is added to the Si melt 33a. Thus, the additional material 34 may not be added to the Si melt 33a simultaneously with the Si pellets 33. The additional materials 34 listed in FIG. 6(a) are merely examples. Alternatively, another type of SiC or C may be charged into the container.

The above-described environment (the temperature, the pressure, and the atmosphere) in which the MSE method is performed is merely an example, and can be modified as appropriate.

A surface of the SiC seed crystal 40 on which the epitaxial layer is to be grown may be arbitrarily selected, and may be a Si surface or a C surface.

In the above-described embodiment, the MSE method is employed as the solution growth method. Alternatively, another solution growth method (e.g., a method for moving an element such as C in a solution by a temperature gradient) may be employed. Even with another solution growth method, it is possible to grow high-purity SiC single crystal by adding SiC or C as the additional material to the Si melt.

### Reference Signs List

- 10: high-temperature vacuum furnace
- 30: housing container
- 31: base material
- 32: seed layer
- 33: Si pellets
- 34: additional material
- 35: first feed material
- 36: cap layer
- 37: second feed material (feed material)
- 40: SiC seed crystal (seed material)

## Claims

1. A method for producing silicon carbide single crystal, comprising:
growing, through a solution growth method, an epitaxial layer on a seed material, at least a surface of which is made of silicon carbide, wherein
the epitaxial layer is grown to yield silicon carbide single crystal whose impurity concentrations measured by secondary ion mass spectrometry satisfy the following conditions:
4.00 × 10¹⁶ or less (atoms/cm³) of aluminum;
3.00 × 10¹⁴ or less (atoms/cm³) of titanium;
7.00 × 10¹⁵ or less (atoms/cm³) of chromium; and
1.00 × 10¹⁵ or less (atoms/cm³) of iron.

2. The method according to claim 1, wherein
the impurity concentrations in the silicon carbide single crystal further satisfy the following conditions:
2.00 × 10¹³ or less (atoms/cm³) of sodium;
1.00 × 10¹⁴ or less (atoms/cm³) of phosphorus;
1.00 × 10¹⁴ or less (atoms/cm³) of calcium;
1.00 × 10¹² or less (atoms/cm³) of vanadium;
5.00 × 10¹⁴ or less (atoms/cm³) of nickel; and
2.00 × 10¹⁴ or less (atoms/cm³) of copper.

3. The method according to claim 1, wherein an additional material that is at least one of silicon carbide and carbon is added to a silicon melt before the growth of the epitaxial layer is ended.

4. The method according to claim 3, wherein a heating treatment is performed on a housing container in which the seed material, solid-state silicon, a first feed material that feeds at least carbon to a silicon melt, and the additional material that is in a solid state exist so that the solid-state silicon is melted into a silicon melt and the additional material is added to the silicon melt.

5. The method according to claim 4, wherein the additional material that is in a solid state is powdery.

6. The method according to claim 3, wherein the epitaxial layer is grown with the housing container in which a first feed material that feeds at least carbon to a silicon melt and a second feed material that adds the additional material to the silicon melt exist.

7. The method according to claim 3, wherein the additional material is silicon carbide.

8. The method according to claim 7, wherein the additional material is more soluble in the silicon melt than the seed material.

9. The method according to claim 3, wherein the additional material is carbon.

10. The method according to claim 9, wherein the additional material is carbon having a true density of 2 Mg/m³ or less.

11. The method according to claim 3, wherein an amount of the additional material to be added to the silicon melt is 1% or more and not more than 3% in an amount-of-substance ratio.

12. A housing container for growing silicon carbide single crystal through a solution growth method involving use of a silicon melt, comprising:
a feed material disposed on at least a surface of the housing container, the feed material adding, to the silicon melt, an additional material that is at least one of silicon carbide and carbon.
